# EUROPEAN PATENT SPECIFICATION

(11) **EP 3 572 874 B1**
(45) Date of publication and mention of the grant of the patent: **19.01.2022**
(21) Application number: 19175800.2
(22) Date of filing: 21.05.2019
(51) Int. Cl.: G03F 7/00, G03F 7/004, G03F 7/028, G03F 7/029

(54) **METHODS FOR MAKING A METAL, SAND OR CERAMIC OBJECT BY ADDITIVE MANUFACTURE AND FORMULATIONS FOR USE IN SAID METHODS**
VERFAHREN ZUR HERSTELLUNG EINES METALL-, SAND- ODER KERAMIKOBJEKTS DURCH GENERATIVE FERTIGUNG UND FORMULIERUNGEN ZUR VERWENDUNG IN BESAGTEN VERFAHREN
PROCÉDÉS DE FABRICATION D'UN OBJET EN MÉTAL, EN SABLE OU EN CÉRAMIQUE PAR FABRICATION ADDITIVE ET FORMULATIONS POUR UNE UTILISATION DANS LESDITS PROCÉDÉS

(30) Priority: 22.05.2018 GB 201808384
(43) Date of publication of application: 27.11.2019
(73) Proprietor: Photocentric Limited, Peterborough, Cambridgeshire PE1 5YW (GB)
(72) Inventor: HOLT, Paul, Peterborough, PE1 5YW (GB); ZAREZADEH, Hanifeh, Peterborough, PE1 5YW (GB); KARMEL, Sarah, Peterborough, PE1 5YW (GB)
(74) Representative: HGF

(56) References cited:
- EP-A1- 2 301 742
- WO-A1-2011/075553
- WO-A1-2017/051182
- JP-A- 2003 241 625
- SHYH-YUAN LEE ET AL: "Development of a Three-Dimensional Slurry Printing System Using Dynamic Mask Projection for Fabricating Zirconia Dental Implants", MATERIALS AND MANUFACTURING PROCESSES., vol. 30, no. 12, 24 November 2014 (2014-11-24), pages 1498-1504, XP055450033, US ISSN: 1042-6914, DOI: 10.1080/10426914.2014.984208

## Description

### Background of the invention

This invention lies in the field of 3D printing, also known as rapid prototyping or additive manufacturing. It is a method of creating three dimensional objects in layers each obtained from a digital representation of the object. Typically, an object is scanned in 3 dimensions or generated digitally by computer-aided design (CAD) and split into layers of a pre-determined thickness. These layers are sequentially sent to a 3D printer which builds each layer of the image and moves the build platform away from the imaging source by the thickness of one layer. The printer then starts the process of creating the next layer on top of the layer just laid down. There are a number of different types of 3D printing and thus different methods of creating these layers.

It is well known in the art to use 3D printing techniques to create a sand, metal or ceramic object using polymer as a temporary or permanent binder to form the desired shape. Some such techniques have been successfully commercialized. All of the known methods use UV light to cure the photopolymer binder.

Broadly, there are two methods of 3D printing sand, metal or ceramic objects. A first method is to deliver a layer of a mixture of particles and photopolymer and then selectively polymerising the desired areas with a controlled exposure system such as a laser, Digital Light Projector (DLP) or similar. A second is to deliver a layer of particles, applying the photopolymer selectively to the desired areas with an ink-jet head dispensing system, spray head or similar, and then exposing those areas to UV irradiation.

Patent applications WO2016/181149 and WO2017/051182 to Holt describe the use of daylight active photoinitators incorporated into photopolymer that is active enough to polymerise by light emitted from commercially available display screens to create 3D objects. Patent Application WO2018/091891 (PCT/GB2017/053442) to Holt describes the use of similar photopolymers as a photopolymer in the 3D printing of metal, sand or ceramic objects.

S. Lee and C. Jiang, Mater. Manuf. Process., 2015, 30, 1498-1504, aims to develop a three-dimensional slurry printing system (3DSP) and to use a two-stage sintering process for the fabrication of zirconia dental implants. A solvent-soluble slurry composed of zirconia powder, visible light-curable resin and methanol is utilised. JP 2003/241625 discloses a volume hologram recording composition for recording the interference fringes produced by interference of coherent light by differences in refractive indices and contains a compound having ≥1 polymerizable functional group(s), a photopolymerization initiator, inorganic particles and a chain-transfer agent. WO 2011/075553 A1 discloses a liquid radiation curable resin for additive fabrication comprising an R-substituted aromatic thioetber triaryl sulfonmm tetrakis(pentafluorophenyl) borate cationic photoinitiator. EP 2301742 A1 discloses a viscosity reducible radiation curable resin composition comprising 5-70 wt% of a difunctional epoxy compound; 0.1-15 wt% of an acrylate having a functionality of larger than 2; 0.1-10 wt% of a thixotropic agent; 0.01-5 wt% of a flow modifier being polyalkyleneoxide modified polydimethylsiloxane; 10-90 wt% of a filler; and at least one photoinitiator.

### Summary of the Invention

In a first aspect of the invention is provided a particulate mixture for forming 3-dimensional objects when exposed to visible light, the mixture comprising:
a liquid photopolymer formulation; and
a plurality of particles, wherein the particles are selected from: sand; a mixture of sand and glass; metal; ceramic; or a mixture of metal and ceramic;
wherein the photopolymer formulation comprises:
at least one monomeric or oligomeric chemical species each comprising at least one carbon-carbon double bond which is polymerisable by free radical polymerisation present in a total amount of from 40 to 98 % by weight;
at least one organometallic or metallocene photoinitiator present in a total amount of from 0.1 to 10 % by weight; and at least one coinitiator present in a total amount of from 0.5 to 20 % by weight,
wherein the components of the photopolymer formulation are selected such that the viscosity of the photopolymer formulation is greater than 800 mPa.s (800 cPs).

In a second aspect of the invention is provided a method for creating a 3D object, the method comprising:
a) forming a layer of a particulate mixture of the first aspect;
b) exposing the layer of the particulate mixture to visible light to form a cured layer; and
c) sequentially repeating steps a) and b), with each layer of particulate mixture being laid on top of each previously cured layer, to form a 3D object formed of particles bound together by cured photopolymer.

The methods of the invention involve metal, sand or ceramic objects being created wherein the material the object is made from is composed of particles of material held together by a polymeric binder. The particles and the polymeric binder are deposited in a layer by layer manner. These layers are sequentially and selectively cured in light above 400nm and below 700nm in wavelength, the light being emitted from a display screen. These can be used to make sand castings for metal moulds or to make solid ceramic or metal objects directly. Ceramic or metal objects made from the 3D printing process can be subsequently sintered to form the eventual ceramic or metal object. The image source is a visual display screen which emits visible light. In contrast, all alternative means of 3D printing sand, ceramic or metal objects use an element of UV light to harden the photopolymer.

Surprisingly, it has been found that by using visible light as the polymerising light it is possible to derive accurate representations of the digital design in an object that consists of solid particles held together by the binder. This provides significant advantages over alternative methods of selective polymerisation, namely lasers and DLPs which create orders of magnitude more energy which has to be absorbed or dissipated in the structure during its creation. The excess unwanted light can compromise the accuracy of the objects eventual resolution because of light striking the irregularity of the position and shape of the particles. In contrast the nature of daylight polymerisation is that the photoinitiator typically has to have colour to absorb visible light photons, which in turn means that it is difficult for the light to transmit deeper into the polymer through the already polymerised pigmented material, thus it becomes self-stabilising in its exposure depth, does not scatter the light and overcomes a lot of the problems in this respect with the prior art.

Furthermore, because the screen exposes every voxel of the area simultaneously across its entire format, it is considerably more effective at polymerising large volumes of solid object than all alternative methods which can only harden a voxel in the case of a laser, or a very small area in the case of a DLP, at a time. The inventors have further found that improvements in the quality, reproducibility and homogeneity of the produced 3D object are increased where the photopolymer binder has a high viscosity. After the final layer has been polymerised, the vat containing the object and uncured matter is transferred to a rinse tank where a solvent is flushed through it to remove the uncured polymer and particles. This mixture can be separated to allow the re-use of the particles.

The resultant structure can optionally be subject to some further post treatment of light illumination or heat if necessary to cure it further. What remains is the desired structure of particles held together by a solidified photopolymer binder. In the case of sand particles, the object can be used as a casting or mould for molten metal. In the case of ceramic or metal particles, the object can be fired to remove the organic polymer and then elevated in temperature towards the sintering temperature of the material at which point the metal or ceramic will fuse together.

The photoinitiator may be a metallocene. The photoinitiator may be a titanocene. The total amount of photoinitiator present in the photopolymer formulation may be from 0.5 to 2.5% by weight. The titanocene may be from: bis(η⁵-2,4-cyclopentadien-1-yl)bis[2,6-difluoro-3-(1H-pyrrol-1-yl)phenyl]titanium, titanocene bis(trifluoromethanesulfonate), titanocene dichloride, (indenyl)titanium (IV) trichloride, (pentamethylcyclopentadienyl)titanium (IV) trichloride, cyclopentadienyltitanium (IV) trichloride, bis(cyclopentadienyl)titanium (IV) pentasulfide, (4R,5R)-chloro-cyclopentadienyl-[2,2-dimethyl-1,3-dioxolan-4,5-bis(diphenylmethoxy)]titanium, (4S,SS)-chloro-cyclopentadienyl-[2,2-dimethyl-1,3-dioxolan-4,5-bis(diphenylmethoxy)]titanium or a mixture thereof. The titanocene may be bis(η⁵-2,4-cyclopentadien-1-yl)-bis(2,6-difluoro-3-(1H-pyrrol-1-yl)-phenyl) titanium.

The total amount of coinitiator present in the photopolymer formulation may be from 1 to 10% by weight. The coinitiator may be a thiol coinitiator. The coinitiator may be selected from 2-mercaptobenzoxazole, 2-mercaptobenzothiazole, 2-mercaptobenzimidazole, pentaerythritol-tetrakis(mercaptoacetate), 4-acetamidothiophenol, mercaptosuccinic acid, dodecanthiol, betamercaptoethanol, 6-ethoxy-2-mercaptobenzothiazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzene thiol, 1-phenyl-1H-tetrazole-5-thiol, 4-phenyl-4H-1,2,4-triazole-3-thiol, pentaerythritol-tetrakis(3-mercaptopropionate), trimethylolpropane-tris(mercaptoacetate), 2-mercaptopyridine, 4-mercaptopyridine, 2-mercapto-3H-quinazoline and 2-mercaptothiazoline or a mixture thereof.

The total amount of the at least one monomeric or oligomeric chemical species each comprising at least one carbon-carbon double bond which is polymerisable by free radical polymerisation present in the photopolymer formulation may be from 70 to 97% by weight.

The total amount of the at least one monomeric or oligomeric chemical species each comprising at least one carbon-carbon double bond which is polymerisable by free radical polymerisation present in the photopolymer formulation may be from 85 to 96% by weight.

The components of the photopolymer formulation may be selected such that the viscosity of the photopolymer formulation is greater than 850 mPa.s (850 cPs). The components of the photopolymer formulation may be selected such that the viscosity of the photopolymer formulation is greater than 900 mPa.s (900 cPs). The components of the photopolymer formulation may be selected such that the viscosity of the photopolymer formulation is greater than or equal to 1000 mPa.s (1000 cPs). The components of the photopolymer formulation may be selected such that the viscosity of the photopolymer formulation is greater than 1500 mPa.s (1500 cPs). The components of the photopolymer formulation may be selected such that the viscosity of the photopolymer formulation is less than 15000 mPa.s (15000 cPs). The components of the photopolymer formulation may be selected such that the viscosity of the photopolymer formulation is less than 5000 mPa.s (5000 cPs). The components of the photopolymer formulation may be selected such that the viscosity of the photopolymer formulation is less than 2000 mPa.s (2000 cPs).

The desired viscosity may be achieved by selecting one monomeric or oligomeric chemical species comprising at least one carbon-carbon double bond which is polymerisable by free radical polymerisation and that has the desired viscosity. The desired viscosity may be achieved by selecting more than one monomeric or oligomeric chemical species each comprising at least one carbon-carbon double bond which is polymerisable by free radical polymerisation and combining them in a proportion that provides a photopolymer formulation having the desired viscosity. The desired viscosity may be achieved by selecting one or more monomeric or oligomeric chemical species each comprising at least one carbon-carbon double bond which is polymerisable by free radical polymerisation that has a lower than desired viscosity and adding a thickener to provide the desired viscosity.

The photopolymer formulation may comprise a thickener, e.g. a silica thickener, illustrative silica thickeners include Gasil 23F and Gasil E140 from PQ Corporation.

The photopolymer formulation may comprise a dispersant. If present, the dispersant may be present in an amount from 0.05 wt% to 5 wt% of the photopolymer formulation. Illustrative dispersants include Disperbik 110, Disperbik 118, Dipserbik 167 and Disperbik 163 from BYK, Edaplan 930, Edaplan 935 and Edaplan 915 and Edaplan 910 from Münzing Chemie GmbH, and EFKA FA, EFKA PU and EFKA PX from BASF.

The photopolymer formulation may comprise a flow modifying agent. If present, the flow modifying agent may be present in an amount from 0.5 wt% to 5 wt% of the photopolymer formulation. Illustrative flow modifying agents include Modaflow Resin, Modaflow 2100, Modaflow 9200 from Allnex, Crayvallac A-2678-M, Crayvallac Flow-100, Crayvallac-PC from Arkema or Rheovis PU, Rheovis PE, Rheovis HS and Rheovis AS from BASF.

The photopolymer formulation may comprise a de-binder. If present, the de-binder may be present in an amount from 1 wt% to 5 wt% of the photopolymer formulation. Illustrative de-binders include waxes, e.g. polyethylene wax, micronized high density polyethylene wax (HDPE), micronized oxidized polyethylene wax, micronized polyurethane wax or similar. The inclusion of a wax, for example, can help with the sintering process. The wax melts earlier on in the steps of burning the elements within the photopolymer, leaving space into which the gases that are generated when the rest of the photopolymer is burnt off can enter and in doing so, prevent blistering and cracking.

The photopolymer formulation may comprise a lubricant. If present, the lubricant may be present in an amount from 1 wt% to 10 wt% of the photopolymer formulation. Illustrative lubricants include Polyethylene glycol 300, Polyethylene glycol 200 and Polyethylene glycol 400 or PAT 672, PAT 657/C and PAT 656 B3R from Wurtz GmbH. Certain lubricants can also act as de-binders.

The at least one monomeric or oligomeric chemical species each comprising at least one carbon-carbon double bond which is polymerisable by free radical polymerisation may comprise Bisphenol A-glycidyl methacrylate (BisGMA). BisGMA is a particularly high viscosity monomer (850,000 mPa.s (850,000 cPs)) that can be used in the methods of the invention. The at least one monomeric or oligomeric chemical species each comprising at least one carbon-carbon double bond which is polymerisable by free radical polymerisation may comprise BisGMA in combination with at least one other monomeric or oligomeric chemical species.

The at least one monomeric or oligomeric chemical species each comprising at least one carbon-carbon double bond which is polymerisable by free radical polymerisation may comprise Urethane dimethacrylate (UDMA). UDMA is a particularly high viscosity monomer (c. 8000 mPa.s (c.8000 cPs)) that has proved very effective in the methods of the invention. The at least one monomeric or oligomeric chemical species each comprising at least one carbon-carbon double bond which is polymerisable by free radical polymerisation may comprise UDMA in combination with at least one other monomeric or oligomeric chemical species. UDMA may be used in combination with Triethylene glycol dimethacrylate (TEGMA). The inventors have found that a combination of UDMA and TEGMA provides a particularly fast and accurate cure.

The UDMA and TEGMA may be present in a weight:weight ratio in the range from 70:30 to 90:10 UDMA:TEGMA. The UDMA and TEGMA may be present in a weight:weight ratio in the range from 75:25 to 85:15 UDMA:TEGMA.

The particles may be sand or mixture of sand and a binder selected from glass and organic binder. It may be that the particles are a mixture of sand and glass. It may be that the particles are sand. It is also possible to make 3D printed sand objects by mixing the sand particles with inorganic binders such as borosilicate glass or low temperature glass. When the 3D objects are made the heat will de-bind the organic resin and fuse the inorganic binder by heat. The photopolymer binder can be used at 20-30% by weight with the inorganic binder at the same ratio of 20-30% by weight.

The particles may be metal or ceramic or a mixture thereof.

The particles may be metal particles. Metal particles may be pure metals or they may be metal alloys, illustrative metals include;
i) Stainless steel: 316L and 17-4PH. Stainless steel 316L can be used for the fabrication of customized medical tools and implants.
ii) Aluminium alloys: AlSiioMg, AlSi₁₂, AlSi₇MgO₆. The main use of these alloys is in the automotive and aerospace industry, due to the low density of aluminium. Aerospace applications often require complex geometrical shapes, which are hard to achieve using conventional shaping methods. Thus, 3D printing of aluminium is a clear advantage in achieving complex geometries.
iii) Cobalt chrome alloys
iv) Titanium alloys: Ti₆Al₄V. The main use is in implantology, due to the biocompatibility of these materials. 3D printing titanium alloys allows for the fabrication of customised, patient specific implants.
v) Nickel based alloys such as Iconickel 718 and Iconickel 625.

The particles may be ceramic and the ceramic may be an oxide ceramic. Oxide ceramics is a widely used class of ceramics. This family includes: Aluminium oxide (alumina), Zirconium oxide (zirconia), Titanium oxide (titania), Zirconia Toughened Alumina (ZTA) and Alumina Toughened Zirconia (ATZ) materials, mixed oxides, spinel, perovskites, ferrites and boron suboxides among others. This class has a wide application, especially when in combination with 3D printing, e.g. the complicated geometrical shapes required in the aerospace industry are often impossible to form using conventional methods and can only be obtained using 3D printing. Zirconia is widely applied in dentistry, especially for crowns and dental implants, which need to be customised and are ideally suited to 3D printing.

The ceramic may be a non-oxide ceramic. Non-oxide ceramics include the family of silicon nitrides, such as Si₃N₄ and SiAlON, silicone carbides, e.g. SiC, SSiC, liquid phase sintered SiC (LPS LiC) OBSC, RBSiC, NSiC, SiSiC, RSiC, boron carbide, boron nitride, aluminium nitride, as well as transition metal borides and carbides. The ceramic may be a silica or silicate ceramic. Silica and silicate ceramics can be used as filler materials for 3D printing, e.g. sand, corderite, mullite, steatite, and zeolites.

The ceramic may be a bioceramic. Bioceramics, such as hydroxyapatite, substituted apatites, and tricalcium phosphate are mainly applied for bone-replacement implants and as scaffold materials. The combination of bioceramics with 3D printing techniques enables the fabrication of customized bone replacement implants with a unique fit to the respective patient.

Further ceramics that might be used in the methods of the invention include, Low Temperature Co-firing Ceramics (LTCC), High Temperature Co-firing Ceramics (HTCC), thermochromic materials, ceramic magnetic materials, piezoceramics, and solid-state conductors such as sodium-beta aluminate.

It may be that the particulate mixture that is formed into a layer is pre-mixed. The methods of the invention may comprise mixing the liquid photopolymer formulation and the plurality of particles to form the particulate mixture. Alternatively, the particulate mixture may be supplied already mixed.

Alternatively, it may be mixed in situ. Thus, it may be that step a) comprises:
forming a layer of the particles; and
applying the liquid photopolymer resin to the particles to form the layer of the particulate mixture.

It may be that the liquid photopolymer is applied uniformly to the particles across the layer. Alternatively, it may be that the liquid photopolymer is applied selectively to certain portions of the layer of particles to form an image, said image being a cross-section of the desired 3D object. It may be that the liquid photopolymer formulation is applied to the particles using an ink jet printer.

It may be that the visible light is from a visual display screen and is in the form of an image, said image being a cross-section of the desired 3D object. It may be that the visual display screen is a LCD screen. Alternatively, where the liquid photopolymer has been applied selectively, it may be that the layer is exposed uniformly to the visible light.

The method may further comprise washing the 3D object comprising the particles bound by the cured photopolymer to remove excess particles and/or excess photopolymer formulation.

Where the particles are metal or ceramic, the method may further comprise heating the 3D object formed of particles bound together by cured photopolymer to form a metal or ceramic 3D object. The step of heating the object may comprise:
heating the 3D object formed of particles bound together by cured photopolymer to a first temperature to remove the cured photopolymer;
heating the resultant 3D object to a second temperature, higher than the first temperature, to sinter the particles to form the metal or ceramic 3D object.

It may be that the object is supported by a heat resistant material as it is heated.

### Brief Description of the Drawings

Embodiments of the invention are further described hereinafter with reference to the accompanying drawings, in which:
FIG. 1 shows an exemplary apparatus suitable for carrying out the methods of the invention. This schematic is shown with a number of layers constructed and the screen in the process of illuminating the layer beneath.
FIG. 2 shows the actions after the completion of the exposure cycle. The screen has now turned off and has been lifted upwards out of the way. The platform that holds the polymerised build object and non-polymerised particles and polymer is then lowered down by one-layer thickness.
FIG. 3 shows the deposit of the layer of particles, either dry or pre-incorporated with photopolymer being swept level by the doctor blade or roller.
FIG. 4 shows the optional stage where the spray head layers an even distribution of photopolymer onto the dry particles.
FIG. 5 shows the screen returning down to come into close proximity to the layer, before commencing the process again described in FIG 1.
FIG. 6 shows the standard of method of operation for the Liquid Crystal Precision and HR printers in the bottom-up configuration.
FIG. 7 shows the standard of method of operation for Liquid Crystal printers in the top-down configuration.
FIG. 8 shows the standard of method of operation for the Liquid Crystal printers in the top-down configuration with a dispensing system.

### Detailed description

The method of the present invention is as defined in claim 11.

The photopolymer and particles of the particulate mixture have to be incorporated together before irradiation. This can be performed in a separate operation, with the polymer mixed into the particles in a separate vat before being transferred to the 3D printer to be levelled as a layer of wet mix. Alternatively, this can be done by delivering a layer of dry particles with the polymer dispensed on top afterwards. This can be performed as two separate steps or combined in a single delivery head.

Preferably, the % weight of particles in the particulate mixture is from 40 to 90% by weight, more preferably from 70 to 85% by weight.

The particles in the particulate mixture of this invention are selected from: sand; a mixture of sand and glass; metal; ceramic; or a mixture of metal and .

The particles are chosen to be of a size and shape to enable their optimal orientation in solid form. The particles may be incorporated at the maximum concentration possible while still enabling the necessary structural strength or permeability to be achieved after light polymerisation of the binding polymer. In the case that the particles are sand or silica they could be quartz, zircon, olivin, magnetite, or a combination thereof. The sand may be virgin sand, reclaimed sand, or a combination thereof. The sand may also include components to make it function better as a foundry mould such as carbonaceous additives. It is desirable that the polymerized structure has the sand particles adhered to each other strongly while still retaining a highly porous structure that is permeable to enable the evacuation of gasses created during the process of the molten metal cooling. In the case of a sand mould it is desirable that less than 30%, less than 10%, or less than 2% of the total weight of the particulate mixture is photopolymer. It may be that more than 20% of the particulate mixture is photopolymer. Preferably the particles are of the same order of size. Preferably they have an average particle size ranging from 10µm to 500µm, more preferably 100µm to 200µm, and still more preferably of the order of 150µm. The sand particles may be mixed with glass particles. In this case, the glass particles may comprise from 20% to 30% by weight of the particulate mixture.

In the case that the particles are metallic or ceramic they are designed to be sintered and the particles are ideally of a narrow distribution in size and of a similar size and shape to achieve a high final density, although dissimilar shapes and sizes are possible. Smaller particles have been found to have more favorable sintering characteristics.

Preferably, the particles have an average particle size of about 1 to 10µm. It may be that the size distribution of the particles has two peaks. It may be that one peak is from 1 to 5µm and another peak is from 5 to 10µm. The two particle sizes have narrow size distributions.

Larger and smaller particle sizes are also possible and the above ranges are not intended as limiting of the invention. Suitable particles are for instance; 26N-0811UPA alpha-alumina with a the mean particle size d50 of 100nm and 99.99% purity from Advanced Materials, AA-03 alpha-alumina single crystals with controlled PDS and almost spherical shape, a mean particle size d50 of 0.44µm from Sumitomo Chemicals, AES-11 alpha alumina particles with a low soda content and MgO additives for easy sintering, a mean particle size d50 of 0.43 µm from Sumitomo Chemicals, P662SB-03 calcinated alpha-alumina with very low sodium and high MgO content, a mean particle size d50 of 1.52µm from Alteo, DAM 07 alpha-alumina particles with low sodium content and almost spherical shape, a mean particle size d50 of 8µm from Denka, DAM 03 alpha-alumina particles with low sodium content and almost spherical shape, a mean particle size d50 of 3 µm from Denka, DAM 01 alpha-alumina particles with low sodium content and almost spherical shape a mean particle size d50 of 1.5 µm from Denka, CY3Z-MA yttrium doped zirconia particles with 0.25% Al2O3, a mean particles size d50 of 0.2µm from Saint-Gobain, Ni-718 particles with a mean particle size d50 of 45 µm from LPW, P122B calcinated aluminium oxide, mostly alpha phase with very low soda content, a mean particle size d50 of 6.5 µm from Alteo and P122SB reactive aluminium oxide, mostly alpha phase with very low soda content, a mean particle size d50 of 2.4 µm from Alteo.

In the present invention, the base of the photopolymer formulation may be based on phenol-formaldehyde, urethane acrylate and epoxy acrylate oligomers. The base of the photopolymer comprises one or more monomeric or oligomeric chemical species each comprising at least one carbon-carbon double bond which is polymerisable by free radical polymerisation. The term oligomer includes compounds having a few monomer units, e.g. dimers, trimers and tetramers etc. of monomers. The photocurable composition may be a suitable oligomer or monomer or combination thereof which can form a polymer of sufficient strength when illuminated with visible light. The oligomer can be created by reacting any suitable polyol with an isocyanate, optionally toluene diisocyanate. This may take place in a stainless steel or glass vessel. The relative proportions of the two reactants are determined by their OH values with the reaction taking place in the presence of a catalyst such as n-butyl tin dilaurate.

Examples of epoxy compounds which may be used in accordance with the present invention are bisphenol A type epoxy resins, bisphenol F type epoxy resins, phenol-formaldehyde epoxy resins, heterocyclic ring-containing epoxy resins such as triglycidyl isocyanurate and hydantoin epoxy, hydrogenated bisphenol A type epoxy resins, aliphatic epoxy resins such as propylene glycol diglycidyl ether and pentaerythrytol polyglycidyl ethers, glycidyl ester type epoxy resins obtained by the reaction of an aromatic, aliphatic or cycloaliphatic carboxylic acid with epichlorohydrin, spiro-ring containing epoxy resins, glycidyl ether type epoxy resins obtained by the reaction of an ortho-allylphenol phenol-formaldehyde compound with epichlorohydrin, glycidyl ether type epoxy resins obtained by the reaction of epichlorohydrin with a diallyl bisphenol compound having an allyl group at the orthoposition with respect to each hydroxy group of bisphenol A, and the like.

Acid anhydrides which may be used as curing agents for the epoxy compounds in accordance with the present invention include phthalic anhydride, hexahydrophthalic anhydride, tetrahydrophthalic anhydride, methyltetrahydrophthalic anhydride, methylhexahydrophthalic anhydride, nadic anhydride, methylnadic anhydride, chlorendic anhydride, dodecenylsuccinic anhydride, methylsuccinic anhydride, benzophenonetetracarboxylic anhydride, pyromellitic anhydride, maleic anhydride and the like. These acid anhydrides are preferably used in an amount of 1.0 equivalent or less based on the epoxy compounds.

The phenolic compounds which may be added to the epoxy resins in accordance with the present invention may for example be, bisphenol A, bisphenol F, bisphenol S, and condensates of formaldehyde and the like with phenols such as phenol, cresol and bisphenol A. These phenolic compounds are preferably used in an amount of 0.8 equivalent or less based on the epoxy compounds. In addition, liquid pre-reacted adducts of such epoxy resins with hardeners are suitable for epoxy resins. It is also possible to use mixtures of epoxy resins in the compositions according to the invention. In the case of sand particles, it is desirable that the material has a high heat deflection temperature. It has been found that compounds containing phenol-formaldehyde resins with a formaldehyde to phenol molar ratio of less than one such as novolac epoxies provide such properties. It is desirable that the photopolymer formulation for sand moulds contain 40-90% of said phenol-formaldehyde resins by volume, more preferably 50-70% by volume. Epoxy phenol formaldehyde resins have a higher functionality with more than 2 epoxy groups per molecule and create high Tg, rigid, hard, heat and chemical resistant photopolymerisable compounds.

In the case of metal and ceramic particles, it is desirable that a functionalised epoxy or urethane (meth)acrylate is used to provide greater reactivity.

Epoxy (meth)acrylates may, for example, be an epoxy (meth)acrylate of a polyepoxy compound such as (poly)ethylene glycol polyglycidyl ether, (poly)propylene glycol polyglycidyl ether, (poly)tetramethylene glycol polyglycidyl ether, (poly)pentamethylene glycol polyglycidyl ether, (poly)neopentyl glycol polyglycidyl ether, (poly)hexamethylene glycol polyglycidyl ether, (poly)trimethylolpropane polyglycidyl ether, (poly)glycerol polyglycidyl ether or (poly)sorbitol polyglycidyl ether, with a hydroxy (meth)acrylate compound such as hydroxymethyl (meth)acrylate or hydroxyethyl (meth)acrylate.

Urethane acrylates are compounds having a radically-polymerizable ethylenic double bond, e.g. one which undergoes addition polymerization by the action of a photopolymerization initiation system when the photosensitive composition is selectively irradiated with daylight. Typical urethane acrylates are poly(meth)acrylate resins, for example polyether urethane polymers, or polyether polyester urethane copolymers such as polyether polyester urethane methacrylate photopolymers, polyester resins, unsaturated polyurethane resins, unsaturated polyamide resins. Upon irradiation, the polymer will undergo crosslinking and become tough and resilient, however in the areas where it is not irradiated it will remain liquid. The epoxy or urethane acrylate is selected to provide the desired rate of polymerisation, toughness and crosslinking properties, while achieving a steady and even burning with low thermal expansion and minimal ash content. In its un-exposed state, it is soluble in a solvent, suitably water so unexposed polymer and is easily removed afterwards. The invention is not limited in use to this choice of oligomer and anyone skilled in the art could construct alternative polymers using alternative oligomers by applying these principles so described.

Experimentation has shown that organometallic and specifically metallocene photoinitiators are most suitable for the invention, most desirably titanocene based photoinitiators give optimum rates of polymerisation. Examples of suitable titanocenes are bis(η⁵-2,4-cyclopentadien-1-yl)bis[2,6-difluoro-3-(1H-pyrrol-1-yl)phenyl]titanium, titanocene bis(trifluoromethanesulfonate), titanocene dichloride, (indenyl)titanium (IV) trichloride, (pentamethylcyclopentadienyl)titanium (IV) trichloride, cyclopentadienyltitanium (IV) trichloride, bis(cyclopentadienyl)titanium (IV) pentasulfide, (4R,5R)-chloro-cyclopentadienyl-[2,2-dimethyl-1,3-dioxolan-4,5-bis(diphenylmethoxy)]titanium, (4S,SS)-chloro-cyclopentadienyl-[2,2-dimethyl-1,3-dioxolan-4,5-bis(diphenylmethoxy)]titanium, and the like. The photoinitator used is most preferably bis(η⁵-2,4-cyclopentadien-1-yl)-bis(2,6-difluoro-3-(1H-pyrrol-1-yl)-phenyl) titanium which is manufactured by BASF under the tradename Irgacure 784 (Irg.784). This photoinitiator reacts mainly to the photons emitted from the blue and green sub-pixels, but not the red in an LCD screen.

It has been found that in systems wherein titanocene based polymer systems are activated solely by daylight, there is no growth until a lower threshold of illumination is reached, then the rate of growth is roughly linear up to an upper threshold of illumination, after that it has been found that the rate of growth with increase in time declines to almost zero. Illumination here means a continuous exposure of the same intensity of daylight for an increasing time measured in seconds. It is proposed that the absence of growth after a threshold is reached may be caused by the relatively low energy of the daylight radiation providing ample opportunity for the photons to strike cured matter and impart their energy instead of travelling further through to reach liquid polymer on the other side of the cured matter. This makes the system in effect, self-stabilising as is significant in compositions where the particular particle loading can deflect the light.

It may be that the total amount of titanocene present is from 0.5 to 5% by weight or more preferably that the total amount of titanocene present is from 0.9 to 2.5% by weight of the photopolymer.

It has been found that the rate of polymerisation can be greatly enhanced by the addition of at least one coinitiator. A coinitiator as referred to in the present invention is a compound that can generate free radicals when itself activated by the activated photoinitiator but which does not itself absorb light in the visible spectrum. The coinitiators can for example be selected from onium compounds, for example those where the onium cation is selected from iodonium, sulfonium, phosphonium, oxylsulfoxonium, oxysulfonium, sulfoxonium, ammonium, diazonium, selenonium, arsenonium and N-substituted N-heterocyclic onium cations wherein N is substituted with an optionally substituted alkyl, alkenyl, alkinyl or aryl (e.g. N-alkoxypyridinium salts); N-arylglycines and derivatives thereof (e.g. N-phenylglycine); aromatic sulfonyl halides; trihalomethylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof, hexaarylbiimidazoles; thiol compounds (otherwise known as mercaptans) (e.g. mercaptobenzthiazoles, mercaptooxadiazoles, mercaptotetrazines, mercaptoimidazoles, mercaptotetrazoles, mercaptopyridines, mercaptooxazoles and mercaptotriazoles; they include 2-mercaptobenzoxazole, 2-mercaptobenzothiazole, 2-mercaptobenzimidazole, pentaerythritol-tetrakis(mercaptoacetate), 4-acetamidothiophenol, mercaptosuccinic acid, dodecanthiol, betamercaptoethanol, 6-ethoxy-2-mercaptobenzothiazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzene thiol, 1-phenyl-1H-tetrazole-5-thiol, 4-phenyl-4H-1,2,4-triazole-3-thiol, pentaerythritol-tetrakis(3-mercaptopropionate), trimethylolpropane-tris(mercaptoacetate), 2-mercaptopyridine, 4-mercaptopyridine, 2-mercapto-3H-quinazoline and 2-mercaptothiazoline); 1,3,5-triazine derivatives with 1 to 3 CX3 groups (wherein every X is independently selected from a chlorine or bromine atom, and is preferably a chlorine atom), such as e.g. 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bistrichloromethyl-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; oxime ethers and oxime esters, such as for example those derived from benzoin; α-hydroxy or α-amino acetophenones; mono-, di- and triacylphosphine oxides, and peroxides.

It has been found that thiol or mercaptan coinitiators are particularly suitable to enhance the rate of growth of polymer when irradiated with low intensity daylight and also provide the finished object with a dry surface finish. Thus, a suitable coinitiator may be a described by the formula X-(SH)n where X represents any organic moiety, and n represents a number from 1 to 10. It is possible to incorporate those mercaptans into resins such as mercapto-modified polyester acrylate resin and these compositions have a similar effect to unmodified thiols in respect of this invention. Preferably, the at least one coinitiator comprises thiol groups. Thus, the coinitiator may be a compound defined by the formula X-(SH)ₙ where X represents any organic moiety, and n represents a number from 1 to 10. Such compounds are hereafter referred to as 'thiols'. Thus, the coinitiator may be selected from 2-mercaptobenzoxazole, 2-mercaptobenzothiazole, 2-mercaptobenzimidazole, pentaerythritoltetrakis(mercaptoacetate), 4-acetamidothiophenol, mercaptosuccinic acid, dodecanthiol, betamercaptoethanol, 6-ethoxy-2-mercaptobenzothiazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzene thiol, 1-phenyl-1H-tetrazole-5-thiol, 4-phenyl-4H-1,2,4-triazole-3-thiol, pentaerythritol-tetrakis(3-mercaptopropionate), trimethylolpropanetris(mercaptoacetate), 2-mercaptopyridine, 4-mercaptopyridine, 2-mercapto-3H-quinazoline and 2-mercaptothiazoline or a mixture thereof. The coinitiator may be pentaerythritol tetrakis(3-mercaptopropionate). The coinitiator may be an oligomeric moiety comprising thiol groups, e.g. a mercaptomodified polyester acrylate.

An 'organic moiety' is intended to mean any hydrocarbyl group or group of hydrocarbyl groups, for example one or more hydrocarbyl group selected from an alkyl group, cycloalkyl group, aromatic group, heteroaromatic group, heterocyclic group, alkenyl group, any of said groups being substituted by or linked together by an aldehyde, halogen, ketone, carboxyllic acid or ester, ether, thioether, amine, amide functionality.

A thiol group is a -S-H group, the -S-H group being typically attached to a carbon atom in an organic moiety. Such groups are sometimes referred to as mercaptans. A thiol coinitiator is a coinitiator that comprises a thiol group.

It may be that the total amount of coinitiator present is from 0.5 to 10% by weight, preferably it may be that the total amount of coinitiator present is from 1 to 5% by weight in the photopolymer.

The composition can, for example, contain certain reactive diluents to bring additional properties to the resin and also modify its viscosity and surface tension. In certain embodiments, the composition further comprises one or more performance-enhancing additives including, for example, esters of acrylic or methacrylic acid, stabilisers, surface tension modifiers and wetting agents.

The formulation may comprise at least one stabiliser to prevent over-exposure. Stabilisers can be either daylight absorbers which convert light into heat, such as 2-hydroxyphenyl-benzophenones, 2-(2-hydroxyphenyl)-benzotriazoles, or 2-hydroxyphenyl-s-triazines, or they are antioxidants that also deactivate the free radicals such as sterically hindered phenols, phosphites and thioethers. Preferably these stabilisers are for example Tinuvin 292 from BASF 1,2,2,6,6-pentamethyl-4-piperidyl methacrylate, 2-hydroxy-4-n-octoxybenzophenone, 2(2'-hydroxy-5'-methylphenyl)benzotriazole or N,N-dimethyl benzylamine. There are also residual amounts of stabilisers such as hydroquinone present in the oligomers and reactive diluents.

Alternatively, the photopolymer formulation may be free of stabilisers. It has been found that these daylight activated formulations do not require any additional stabilisers as the intensity of light present in non-intended areas is below the threshold necessary to initiate polymerisation. This is important in the creation of high resolution sand, metallic and ceramic loaded objects as these particles can refract the light after impact and create over-exposure. Alternative photocurable chemistries are also possible and the above types are not intended as limiting of the invention.

The desired thickness of the layer of particles may vary depending on the desired precision of the stereophotolithographic layering and the depth of cure provided by the mixture. Preferably, the layer thickness is from 25 to 500µm, more preferably from 50 to 250µm. It will be understood that layer thickness is subject to manufacturing tolerance, which may cause a microscopic difference in thickness of two layers that would be considered to be of the same thickness. The thicker the layers, the less time is needed to polymerise the total object, but countering this very thick layers containing particles are slow to fully polymerise. Preferably, the time to expose each layer is less than two minutes, more preferably it is less than one minute.

In the case of 3D printing using photopolymer containing high solid particle contents e.g. sand, metal or ceramics, the particulate mixtures are not disposed to be positioned evenly into thin coatings quickly by liquid flow alone. It is therefore more practical to deposit an even layer of the dry solid particles and uniformly coat with photopolymer or to deposit a layer of pre-coated particles, and then to selectively harden the layer. Each layer of cured polymer is a 2D image, representing a cross-section of the completed object. It may be that all layers of cured polymer form different images.

The screens used in certain methods of the invention may be suitable for human viewing. The screens used in certain methods of the invention may emit little or no UV radiation.

The visual display screen may be a television, a computer monitor, a laptop, a mobile device such as a smart phone or a tablet computer such as an iPad^{®}. The screen may be unmodified after manufacture. Alternatively, the screen may be back-lit with a visible light source, e.g. an array of LEDs.

LCD screens manufactured for human viewing are typically illuminated by LED backlights. As LEDs used to backlight LCD screens emit a single frequency they have no emissions in the UV region. Visual display screens adapted for human viewing typically emit no light in the UV region. The screen of the invention may emit less than 5% UV light, e.g. less than 1%. The distribution of wavelengths emitted by a screen will typically be available as a graph as part of the manufacturer's technical data package. Integration of the relevant portions of that graph can be used to determine the proportion of the light emitted which is UV light. The distribution of radiation, and therefore the relative proportions of the components of that radiation, may also be determined using a light meter configured to measure the amount of light emitted across the appropriate ranges of wavelengths.

It may be that the visual display screen has a luminance of between 100 and 5000 (e.g. between 100 and 2000) candela per square metre (cd/m²). Thus, it may be that the visual display screen has a luminance of between 200 to 400 cd/m². The visual display screen may have a luminance of greater than 175 cd/m². The visual display screen may have a luminance of greater than 500 cd/m². The luminance is intended to mean the total luminance, i.e. the sum of the individual luminances for UV radiation, visible light, IR radiation, etc. and may be determined using a light meter configured to measure the amount of light emitted across the range of wavelengths emitted by the screen. Thus, the luminance of a screen can be measured using a luminance meter such as the LS-100 made by Konica. This instrument can provide accurate measurements of the cd/sqm and produce and accurate relative photopic luminosity curve. The test procedure is to turn the screen on for 5 minutes to allow it to reach maximum emission and then in a dark enclosure place the LS-100 on the screen and take the reading in cd/ m².

The visual display screen may be an LCD. The visual display screen may be an LED, an organic light emitting diode type (OLED), a polymer light emitting diode type (PLED), an electroluminescent display type (ELD) or a plasma display panel type (PDP) or other. The type of screen is not critical to this invention, merely that it displays images and that those images are in daylight. This invention utilises novel photopolymer formulations which are highly active in the visible light region. This enables the use of unmodified LCD screens manufactured for human viewing with light generated by light emitting diode (LED) backlights that are emitting solely daylight. As LEDs emit a single frequency they have no emissions in the ultra violet (UV) region.

An LCD screen typically consists of an array of pixels. Each pixel consists of a layer of liquid crystal molecules aligned between two transparent electrodes and two polarizing filters (parallel and perpendicular), the axes of transmission of which are, in most of the cases, perpendicular to each other. Before an electric field is applied, the orientation of the liquid-crystal molecules is commonly twisted, the surface alignment directions at the two electrodes are perpendicular to each other and so the molecules arrange themselves in a helical structure. By controlling the voltage applied across the liquid crystal layer in each pixel, light can be allowed to pass through in varying amounts thus creating different levels of grey.

It may be that the visual display screen has 39.37 pixels per cm (100 pixels per inch) or greater. It may be that the visual display screen has 68.90 pixels per (175 pixels per inch) or greater. It may be that the visual display screen has a ratio of its contrast ratio to its luminescence that is above 1.0.

The length of time that the screen illuminates the image is determined by the rate of curing of the photopolymer and the intensity of light being emitted from the screen thus curing it.

The photopolymer may be in direct contact with the visual display screen. The photopolymer may be separated from the visual display screen by a gaseous layer. The photopolymer may be separated from the visual display screen by a filmic layer. It may be that the film is a perfluoroalkoxy copolymer (PFA) or a fluorinated ethylene propylene (FEP). It may be that the visual display screen is coated with a low surface energy coating, e.g. a silicone coating. It may be that the top of layer of photopolymer and particles is in direct contact with the visual display screen.

The solid object may be formed on a build platform within the 3D printer in which the build platform is lowered by the thickness of a layer into the machine housing and particles and photopolymer are dispensed into the tray to the level of the upper surface of the tray. In practice, they can be smoothed level by a doctor blade, a counterrotational roller or similar device. The housing and build platform are desirably made from a light strong and non-flexible material, preferably aluminium or stainless steel.

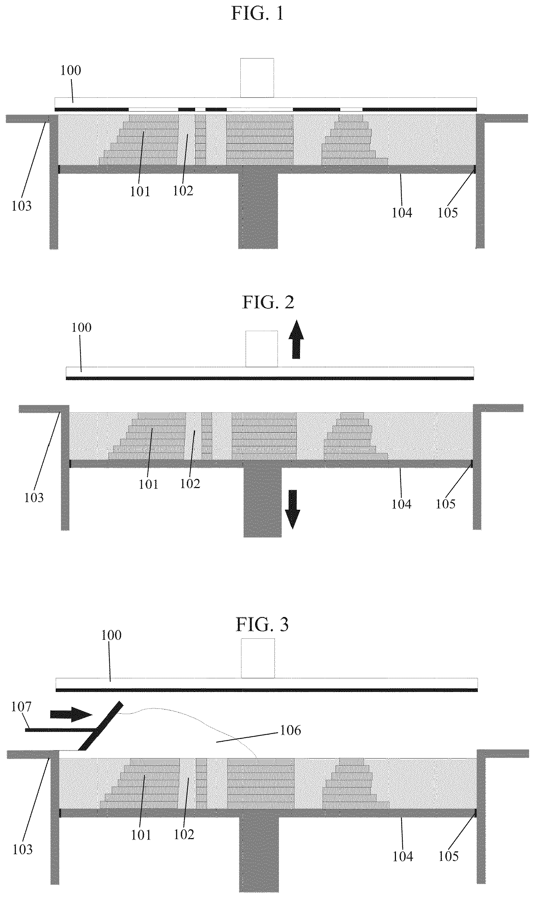

FIG. 3 shows this configuration where 100 is a visible light emitting display screen to provide the selective illumination. The particles 106 are smoothed out by a doctor blade 107 (a roller could also be used) to deliver them level with the top of the machine 103. A seal is made between the build platform 104 and the machine housing 103 using a gasket 105. The build platform supports both solidified material 101 and uncured polymer and particles 102.

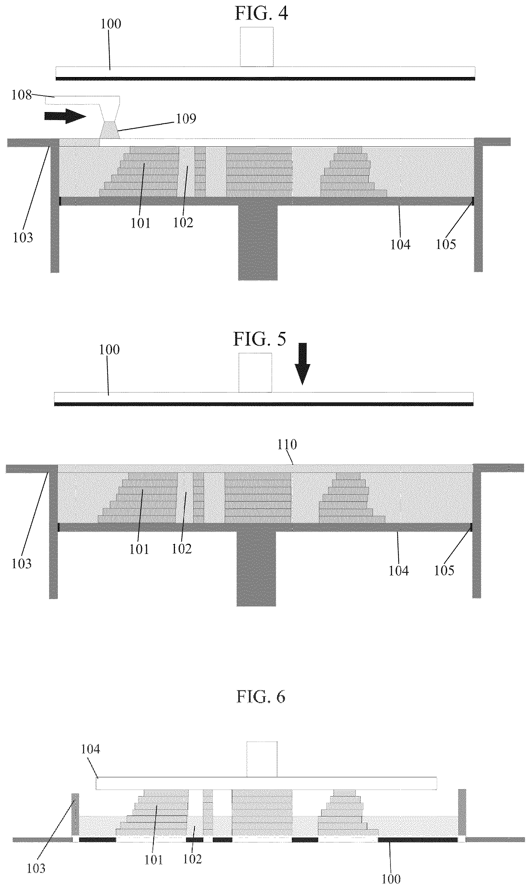

FIG. 4 shows the even delivery of photopolymer 109 from the spray head 108 over the particles to produce coated particles 102. In the case of a sand object being created the photopolymer is preferably delivered in a thin layer to coat the sand particles and adhere them together with a large percentage of the volume remaining air. In the case of metal and ceramic particles very little, if any of the voids between the particles remains as air.

FIG. 5 shows the lowering of the display screen 100 down to be in close proximity with the uncured polymer and particles 110.

FIG. 1 shows the display screen in its illumination cycle, with a pattern of illumination corresponding with the desired curing pattern of the uncured, uppermost polymer layer, for converting the uncured polymer layer 110 selectively into uncured 102 and cured 101 polymer areas.

FIG. 2 shows the screen 100 being lifted upwards and the build platform 104 being lowered, before repeating the process in FIG 3.

FIG. 6 shows the exemplary apparatus for carrying out the methods of the invention in the manner of operation of the Liquid Crystal Precision and Liquid Crystal HR printers from Photocentric, Peterborough. These are the techniques by which all of the samples in Examples 6-25 are fabricated. The screen illuminating the photopolymer mixture is static (100) and placed underneath the photopolymer resin (102) which is contained in a vat (103). The platform (104) moves up and down along the z-axis. The printing is started with the platform in the lowest possible z-value or home position while the screen displays a 2D slice of the 3D object. Prior to the print, a computer aided drawing of the object has been processed to a series of 2D slices in a software package. Once the screen displays a slice, the illuminated pixels lead to a selective cure of the photopolymer. This process is called curing a layer. Subsequently, the platform moves up and comes down to the previous z-position minus the height of one single layer. This process is repeated multiple times until the 3D object (101) is obtained. This method is called bottom-up printing.

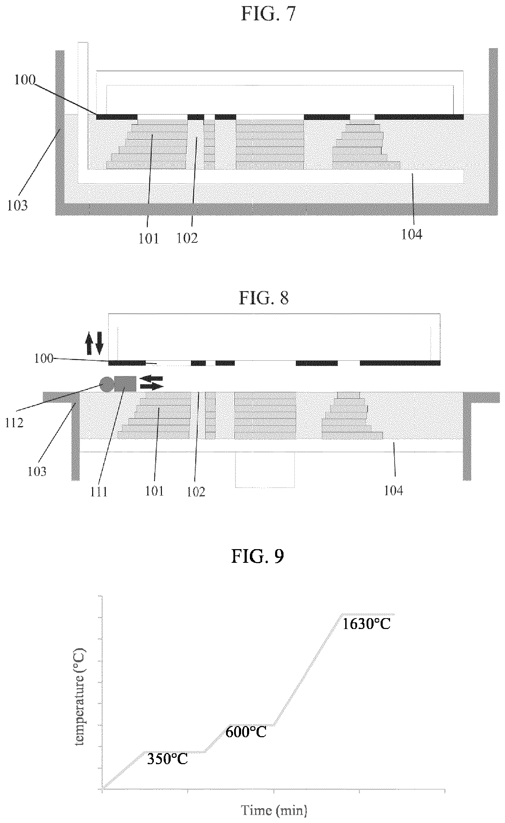

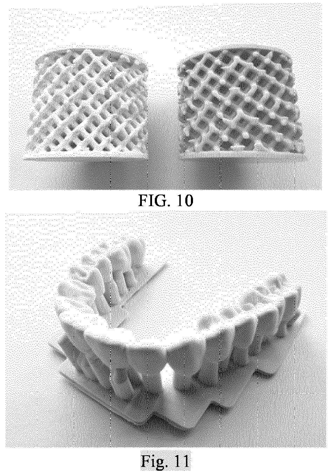

FIG. 7 shows the exemplary apparatus for carrying out the methods of the invention in the form of the Liquid Crystal top-down printer. This is a top-down printer, in which the screen (100) is fixed to the z-axis on top of a deep photopolymer vat (103). The build platform (104) is surrounded by the vat and moves downwards from the home position to build the 3D object. Similar to first exemplary, the screen displays a 2D image of a slice for a few seconds, the liquid photopolymer (102) cures and attaches to build platform. This process leads to the formation of the first layer. There is an optional air gap between the screen and photopolymer to assist the peeling process for upcoming layers. Subsequently, the platform moves away from screen (100) to build consecutive layers following the sequence of steps to complete the formation of a 3D object (101).

The benefit of the proposed top down static technique is to prevent peeling issues and to avoid heavy parts falling from platform. Ceramic and metal slurries are 5-10 times heavier than pure photopolymer resins, and larger parts tend to fall down from build platform while printing via the bottom-up exemplary method.

FIG. 8 shows the third exemplary apparatus for carrying out the methods of the invention which incorporates a dispensing system. This apparatus is a top-down printer with a modified dispensing system for viscous ceramic and metal loaded resins. The screen (100) moves perpendicular to the print platform (104). The vat (103) contains a print platform which moves down along the z-axis with the 3D object (101) being formed layer by layer on the print platform. The photopolymer injector (111) and leveler (112) both move laterally across the print platform. Subsequently, the screen moves vertically down towards the print platform optionally enabling an airgap between the dispensed photopolymer layer (102) and the screen. The screen then displays a 2D image which leads to a selective hardening of the photopolymer. The screen moves vertically away from the screen and the process is repeated until the 3D object is obtained.

The benefit of this technique in comparison to the top-down is that the preparation of the next layer is not dependent on the metal and ceramic slurry flow behaviour. In addition, higher solid loadings in the slurry can be used in comparison to the previously described methods, achieving better sintering and debinding performance.

After completion of the hardening process the uncured photopolymer and particles are removed and transferred to be washed or similar. The solvent used in the washing process may be a combination of warm water and a surfactant or can be a solvent such as isopropanol. Preferably, the object is then dried and can optionally could be post-cured by exposure to a flood of light or heat.

In the case of sand moulds, the mould is useful for the manufacture of moulds for the casting of metals. Without limitation, examples of the use of the methods of the present invention include the formation by metal casting for an automotive component or similar. The cavities in the sand mould are filled with the molten metals and the voids between the sand particles create permeability which allows the evacuation of gases.

In the case of metal and ceramic objects the finished object is of use as a solid metal or ceramic item. To achieve this the cured item is fired to a first temperature remove the photopolymer (and other organic components) and then increased in temperature up to a level necessary to fuse the sinterable inorganic particles. Typically, the first temperature is from 500 to 700°C. The overall heating rate during the photopolymer removal is preferably from 1 to 25°C/hr. Photopolymer removal may comprise an initial heating process (heating up to about 200-300°C) at which the heating rate is from 1 to 15°C/hr; and a second stage at which the heating rate is from 15-25°C. The object may be held at 200-300°C for a period of time (e.g. 0.5-2hr). It has been found that a slower heating rate during this phase provides the best results. Possibly, this is because gases are generated when the photopolymer is burnt off and if these gases are formed too quickly, it can cause blistering and cracking. Burning the photopolymer off slowly, however, reduces or eliminates these problems. Once the organic polymer is removed, the object is then heated to a sintering temperature appropriate for the inorganic material(s) to be fused. Preferably, the sintering is conducted to the temperature that the body has a density of at least 90% of the theoretical maximum density for the sinterable material, more preferably to at least 95% of theoretical density, most preferably at least 98% theoretical density.

The method may comprise the steps of (1) coating a first layer of the particles onto a surface; (2) coating a layer of photopolymer onto the particles; or alternatively (3) coating a combined layer of photopolymer and particles; (4) exposing said layer to the light emitted by the visual display screen to form the first layer of cured or partially cured polymer; (5) coating a second layer of the liquid photopolymer and particles onto the first layer of cured or partially cured polymer in the same manner; (6) exposing said second layer to the light emitted by the visual display screen to form a second layer of cured or partially cured polymer; (7) repeating steps (4) and (5) at least once to build up the three-dimensional object.

The wavelength of the light is a wavelength suitable to create polymerisation in the liquid polymer, this wavelength may be between within the spectrum visible to the human eye, i.e. above 400nm and below 700nm. The illumination source may be an LCD screen. In the case that the LCD screen provides selective illumination, the light partly exposes an area of a thin layer of the liquid, solidifying it to form the relevant layer of the shape that is being created. The shape of the cured polymer within that layer is determined by the shape of the image created on the LCD screen.

It has been found that the optimal resolution of the screen is obtained from screens with a high ratio of contrast ratio to total luminance. The contrast ratio of an LCD system is defined as the ratio of the luminance of its brightest colour (white) to that of its darkest colour (black). It has been found that ideally the contrast ratio should be above 1.0 and it is desirable for it to be as high as possible.

### EXAMPLES

Various aspects of the invention will now be particularly described with reference to the following examples, which were all performed using the following procedures described below.

Comparative Examples 1 to 5 were carried out using photopolymer binders that have a viscosity less than 800 mPa.s (800cPs) and therefore do not form part of the present invention.

### Illustrative printer

This is a description of the apparatus used in comparative Examples 1 to 5. All elements of the printer were constructed out of stainless steel unless explicitly stated. Two linear drive NEMA 17 motors with 8mm lead screw and 1mm pitch supplied by Lankeda were housed vertically in alternate sides of a chassis. One linear drive was used to support a replacement iPad^{®} screen, shown as 100 in FIG. 1, of the dimensions 160mm x 120mm. The iPad was connected with flexible cabling enabling it to retract freely to its most elevated position, up to 200mm above the base of the unit. This was fitted so the screen was horizontal and facing downwards and was used as the LCD daylight illumination device. The other linear drive was used to support the moveable build platform of dimensions 160mm x 120mm, shown as 104 in FIG. 1. The build platform was sealed into an opened bottomed vat of size 162mm x 122mm size with a 2mm diameter silicone gasket shown as 105 in FIG. 1. A doctor blade was supported at an angle of 45° to the vertical and 90° to the direction of travel, either side of the build platform, in bearing assemblies that enable free movement down the unit. Both linear motors could move freely up and down delivering accurate z-axis movement of 25µm.

### Comparative Example 1 - Pre-mixed sand and photopolymer

In this experiment 100g of photopolymer was constructed in the following manner; 95g of Ebecryl 639 from Allnex of Belgium, which is a high functionality acrylated epoxy novolac resin diluted with 30% of Trimethylolpropane triacrylate (TMPTA) and with 10% of Hydroxy ethyl methacrylate (HEMA), was added to 2g of bis(eta5-2,4-cylcopentadien-1-yl)-bis(2,6-difluoro-3-(1H-pyrrol-1-yl)-phenyl) titanium under the brand name Irgacure 784 from BASF and 3g of Pentaerythritol Tetra(3-mercaptopropionate) under the brand name Thiocure PETMP from Bruno Bock. The solution was added to a glass vessel and mixed for 6 hours until the initiators were fully dissolved.

1kg of Congleton HST 50 sand was obtained from Sibelco Minerals and Chemicals and was loaded into a mixing container. 50g of the photopolymer was sprayed over the top of the sand so that it was completely covered. The contents of the container were given slow agitation for 10 minutes until the mix was homogenous. The container was left to stand for one hour to allow the excess polymer to drain to the bottom and sand was removed from the top. To achieve homogenous mixing, 15g of volatile compatible solvent was added to the mixture, e.g. in this case isopropyl alcohol has been added. The mixture was vigorously mixed for 4 hours in an open lid container which allowed the solvent to fully evaporate.

The screen was elevated to the top of the linear drive. The print platform was lowered to be recessed by 0.1mm from the top of the printer. A total of 5g of the sand evenly coated with photopolymer was laid at one end of the 3D printer in front of the doctor blade. Constant force was delivered to both sides of the blade to evenly fill the recess in the vat to a depth of 0.1mm, the cavity taking approximately 2.5g of material, the excess being swept to the other side to be subsequently topped up and reused on the next pass.

The screen was lowered to its base position resting on top of the 3D printer, in this position it was approximately 0.1mm above the level of the top of the layer. A mould for an object to be made was obtained digitally in three-dimensions, it was sliced and stored in stl format. The driver board for the iPad screen was set to generate maximum brightness, this was measured at 750 cd/m². The first sliced image was transferred to the iPad and it was left illuminating in black and white for a total of 40 seconds. The screen was then lifted again to its uppermost position; the print platform was lowered by a further 0.1mm and the process was repeated. After a total of 55 layers were made, the mould consisting of a number of cavities, was complete. The print platform was raised and transferred to a washing unit. Isopropyl alcohol was rinsed through to remove the unpolymerised photopolymer and sand. After 3 minutes, all the channels were flushed through and the mould was placed in an air-drying oven at 40°C for one hour. The mould exhibited good operational strength and high heat deflection temperatures while at the same time the majority of the structure was open and gas permeable. It was further possible to prove its functionality when it was used to recreate that object in molten metal.

### Comparative Example 2 - Sand and photopolymer separately delivered in a 3D printer

In this experiment 100g of photopolymer was constructed in the following manner; 75g of Ebecryl 639 from Allnex, 20g of Hexanediol diacrylate from Allnex, 2g of Irgacure 784 and 3g of Thiocure PETMP were mixed in a glass vessel for 6 hours until the initiators were fully dissolved.

1kg of Nugent 480 sand was obtained from the Nugent Sand Co Inc. and was loaded into a mixing container. The screen was elevated to the top of the liner drive. A Xaar 1003 GS6 inkjet head with 141.73 nozzles per cm (360 nozzles per inch) delivering greater than 1000dpi, was loaded with the photopolymer. The photopolymer was heated to make the viscosity compatible with the Xaar1003 GS6 printhead and was made to dispense resin selectively. The print platform was lowered to be recessed by 0.1mm from the top of the printer. The sand was evenly delivered into the recess by the doctor blade. The ink-jet head was given the same data as was directed over the sand, matching the illuminated sections of the screen in area. The inkjet head was then primed and set to deliver the minimum amount to just coat the sand, without flooding it, by experimentation this was found to be a drop volume of 6pL. The resin and polymer on the platform was left to stand for 30 seconds for the resin to distribute through the layer thickness.

The screen was lowered to its base position resting on top of the top of the 3D printer, in this position is was approximately 0.1mm above the level of the top of the layer. As before, the driver board for the iPad screen was set to generate maximum brightness and the first sliced image was transferred to the screen for a total of 40 seconds. The screen was then lifted again to its uppermost position; the print platform was lowered by a further 0.1mm and the process was repeated. After a total of 55 layers, the mould providing a number of cavities, was complete. The print platform was raised and removed to a washing unit. Isopropyl alcohol was rinsed through it to remove the loose sand and photopolymer. After 3 minutes, all the channels were flushed through and the mould was placed in an air-drying oven at 40°C for one hour. The mould was then used to recreate that object in molten metal. The mould was dimensionally strong, with a slightly lower gas permeability than in Example 1.

### Comparative Example 3 - Pre-mixed sand, borosilicate glass particles and photopolymer

In this experiment 1kg of photocurable slurry was manufactured. 500g of Cerabeads 1450, with 300g of Potters beads (Spheriglass^{®} 5000 Solid Glass Spheres), 200g of photosensitive resin with some low melting points additives (around 3% wt), and 3% of flow agents. After mixing the components with a high shear mixer rotating at 12,000 rpm for 30 minutes the sand mixture was dispensed at 150 µm (150 micron) layer thickness and hardened by a LCD screen emitting visible light. After the 3D object was made it was post cured under visible light for 2 hours. The object was placed in the oven and slowly increased by 1°C /min from 200°C to 450°C. It was held at 450°C for 2 hours and then slowly increased by 2°C /min up to 750°C, where the glass particles started softening and passing their glass transition point. The object was hold for 30 mins at the highest temperature and the gradually cooled (with the furnace switched off). Molten metal at below 1000°C was poured to the manufactured mould and a successful cast metal object was derived.

### Comparative Example 4 - Aluminium and photopolymer separately delivered in a 3D printer

In this experiment 100g of photopolymer was constructed in the following manner; 55g of Ebecryl 8307 is a urethane acrylate with high flexibility and excellent adhesion on metal made by Allnex, 20g of Hexanediol diacrylate from Allnex, 20g of Genomer 1122TF a monofunctional monomer from Rahn, 2g of Irgacure 784 and 3g of Thiocure PETMP were mixed in a glass vessel for 6 hours until the initiators were fully dissolved.

AlSi 12 aluminium alloy powder at average size 58µm was obtained from Easy Composites Ltd and was loaded into a mixing container. A Xaar 1003 GS6 inkjet head with 141.73 nozzles per cm (360 nozzles per inch) delivering greater than 1000dpi, was loaded with the photopolymer.

The screen was elevated to the top of the liner drive. The print platform was lowered to be recessed by 0.1mm from the top of the printer. The AlSi powder was evenly delivered into the recess by the doctor blade. The inkjet head was then primed and set to deliver the maximum amount, fully coating the AlSi powder, by experimentation this was found to be a drop volume of 24pL. The ink-jet head made a dispense pass over the AlSi powder, the platform was left to stand for 30 seconds for the resin to distribute through the layer thickness.

The screen was lowered to its base position resting on top of the top of the 3D printer, in this position is was approximately 0.1mm above the level of the top of the layer. As before the driver board for the iPad^{®} screen was set to generate maximum brightness and the first sliced image was transferred to the screen for a total of 40 seconds. The screen was then lifted again to its uppermost position; the print platform was lowered by a further 0.1mm and the process was repeated. After a total of 55 layers, the aluminium object held in shape by the photopolymer was complete. The print platform was raised and removed to a washing unit. Warm water and detergent were added to the water bath and it was sprayed throughout its structure, removing the loose AlSi powder and photopolymer. After 5 minutes the object was clean and was placed in an air-drying oven at 40°C for 20 minutes. The unbound AISi powder was reclaimed by filtration.

The AlSi-based object was placed into a ceramic cylinder and packed with ceramic beads to support it. It was stepped up in temperature from room temperature to 250°C, over 4 hours (approx. 60°C per hour), then it was held at 250°C for 4 hours, then elevated from 250°C to 630°C, over 4 hours (approx. 100°C per hour), it was held at 630°C for 4 hours. Heat was turned off and it was allowed to cool naturally with the furnace door ajar, back to room temperature. An accurate representation of the object was created in solid aluminium. Its relative density was measured at 94%.

### Comparative Example 5 - Silver and photopolymer separately delivered in a 3D printer

In this experiment the photopolymer was constructed in the same manner as Experiment 4. Silver powder with particle sizes between 4-7µm was obtained from Alfa Aesar and was loaded into a mixing container. As before, the same ink-jet delivery system was used and was loaded with the photopolymer.

The screen was elevated to the top of the liner drive. The print platform was lowered to be recessed by 0.1mm from the top of the printer. The sand was evenly delivered into the recess by the doctor blade. The inkjet head was then primed and set to deliver the maximum amount, fully coating the silver, by experimentation (as this depends upon particle surface shape and rheology and polymer flow characteristics) this was found by experimentation to be a drop volume of 18pL. The inkjet head made a dispense pass over the silver, the platform was left to stand for 30 seconds for the resin to further distribute.

The screen was lowered to its base position resting on top of the top of the 3D printer, in this position is was approximately 0.1mm above the level of the top of the layer. As before the driver board for the iPad screen was set to generate maximum brightness and the first sliced image was transferred to the screen for a total of 40 seconds. The screen was then lifted again to its uppermost position; the print platform was lowered by a further 0.1mm and the process was repeated. After a total of 55 layers, the silver object held in shape with photopolymer, was complete. The print platform was raised and removed to a washing unit. Warm water and detergent were added to the water bath and it was sprayed through removing the loose silver and photopolymer. After 5 minutes the object was clean and was placed in an air-drying oven at 40°C for 20 minutes. The un-bound silver powder was reclaimed by filtration.

The silver object was placed into a ceramic cylinder and packed with sand to support it. It was stepped up in temperature from room temperature to 250°C, over 4 hours (approx. 60°C per hour), it was held at 250°C for 4 hours, then elevated from 250°C to 750°C over 5 hours (approx. 100°C per hour) and finally held at 750°C for 4 hours. Heat was then turned off and it was allowed to cool naturally with furnace door ajar, letting it fall back to room temperature. An accurate representation of the object was created in solid silver. It was assayed at 92.5% solid silver.

Examples 6 to 12 were carried out using the commercial Liquid Crystal HR Printer from Photocentric Peterborough. In this apparatus the screen illuminating the photopolymer mixture is static and placed underneath the photopolymer resin which is contained in a vat. The platform moves up and down along the z-axis. The printing is started with the platform in the lowest possible z-value or home position while the screen displays a 2D slice of the 3D object. Prior to printing, a computer aided drawing of the object has been processed to a series of 2D slices in the software. Once the screen displays a slice, the illuminated pixels lead to a selective cure of the liquid photopolymer. This process is called curing a layer. Subsequently, the platform moves up and comes down to the previous z-position minus the height of one single layer. This process is repeated multiple times until the 3D object is obtained. Examples 6 and 7 are comparative and do not form part of the present invention.

### Comparative Example 6

The following materials were weighed; Bisphenol A (EO10) Dimethacrylate 123g, 1,6-hexanediol diacrylate 30g, Tricyclodecane dimethanol diacrylate 20g, Trimethylpropane triacrylate 17g, Pentaerythritoltetra(3-mercaptopropionate) 6g, bis(η⁵-2,4-cyclopentadien-1-yl)-bis(2,6-difluoro-3-(1H-pyrrol-1-yl)-phenyl) titanium 4g, P122SB 400g, P122B: 200g and Edaplan 930 2ml. The viscosity of the photopolymer binder was 560 mPa.s (560cPs). A 500ml metal tin was loaded with the quantities described in Comparative Example 1 of all of the following; Bisphenol A (EO10) Dimethacrylate, 1,6-hexanediol diacrylate, Tricyclodecane dimethanol diacrylate, Trimethylpropane triacrylate and Pentaerythritoltetra(3-mercaptopropionate). The alumina powders were added portion-wise while using the high shear mixer (1000-4500 rpm), at the same time the Edaplan 930 was added via a syringe. P122B was added first to the liquid monomer mixture and only after all of the P122B was added was the P122SB added portion-wise. After all the solid alumina powder was added, the bis(η⁵-2,4-cyclopentadien-1-yl)-bis(2,6-difluoro-3-(1H-pyrrol-1-yl)-phenyl) titanium was added to the mixture while it was still hot. The reaction mixture was placed in the oven at 50 degrees for 48 hours until all of the photoinitiator had dissolved. However, after about 12 hours the alumina powder started to settle to the bottom of the photopolymer and the resultant print was of a poor quality.

### Comparative Example 7

The following materials were weighed; Neopentylglycol(PO)2 Diacrylate 190g, Pentaerythritoltetra(3-mercaptopropionate) 6g, bis(η⁵-2,4-cyclopentadien-1-yl)-bis(2,6-difluoro-3-(1H-pyrrol-1-yl)-phenyl) titanium: 4g, P122SB 311g, P122B: 156g, Modaflow 900 (flow modifier) 0.3ml and Edaplan 930 (dispersant) 0.9 ml. The viscosity of the photopolymer binder was 30 mPa.s (30 cPs). A 500 ml metal tin was loaded with the quantities described above of Neopentylglycol(PO)2 Diacrylate and Pentaerythritoltetra(3-mercaptopropionate). The alumina powders were added portion-wise while using the high shear mixer (1000-4500 rpm), at the same time while adding Edaplan 930 via syringe. P122B was added first, followed by the addition of Modaflow, and subsequently, P122SB was added. The photoinitiator was added to the warm reaction mixture, which was kept in the oven at 50 degrees until all photoinitiator was dissolved (12 hours). This resin printed high resolution test pieces successfully and dogbones were printed on the Liquid Crystal HR printer supplied by Photocentric at exposure times of 65 seconds exposure time per 100 µm (100 micron) layer. The strength of the ceramic part was very weak however. The particles dropped out of the suspension after 3 days.

### Example 8

The following materials were weighed; Urethane dimethacrylate (UDMA) 135g, Triethylene glycol dimethacrylate (TEGMA) 55g, Pentaerythritoltetra(3-mercaptopropionate) 6g, bis(η⁵-2,4-cyclopentadien-1-yl)-bis(2,6-difluoro-3-(1H-pyrrol-1-yl)-phenyl) titanium 4g, P122SB 57g, P122B 29g and Disperbik110 (dispersant) 1ml. The photopolymer binder viscosity was 1100 mPa.s (1100 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik 110 via syringe. P122B was added first, followed by the addition of P122SB. The photoinitiator was added to the warm reaction mixture, which was kept in the oven at 50 degrees until all of the photoinitiator had dissolved (12 hours). The printing of high resolution parts was completed successfully. Dogbones were printed on the Liquid Crystal HR printer at 45 seconds for 100 µm (100 micron) layers. The unsupported dogbones were very hard to remove from the build platform, but the supported ones were very high quality. The particles didn't drop out after 1 week.

### Example 9

The following materials were weighed; Urethane dimethacrylate: 95g, Triethylene glycol dimethacrylate 55g, Pentaerythritoltetra(3-mercaptopropionate) 6g, bis(η⁵-2,4-cyclopentadien-1-yl)-bis(2,6-difluoro-3-(1H-pyrrol-1-yl)-phenyl) titanium 4g, P122SB 311g, P122B 156g, Disperbik110 (dispersant) 3ml and Edaplan 930 0.3ml. The viscosity of the photopolymer binder was 1000 mPa.s (1000 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik110 via syringe. P122B was added first, followed by the addition of P122SB and Edaplan 930. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. Dogbones were printed on the Liquid Crystal HR printer at 60 seconds for 100 µm (100 micron) layers. Larger structures than dogbones were then successfully printed

### Example 10

The following materials were weighed; Urethane diemthacrylate 95g, Triethylene glycol dimethacrylate 55g, Pentaerythritoltetra(3-mercaptopropionate) 6g, bis(η⁵-2,4-cyclopentadien-1-yl)-bis(2,6-difluoro-3-(1H-pyrrol-1-yl)-phenyl) titanium 4g, P122SB 400g, P122B 200g, Disperbik110 (dispersant) 3ml and Edaplan 930 0.3ml. The viscosity of the photopolymer binder was 1000 mPa.s (1000 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik110 via syringe. P122B was added first, followed by the addition of P122SB and Edaplan 930. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. The resin was however, very viscous. Dogbones were printed on the Liquid Crystal HR printer at 75 seconds for 100 µm (100 micron) layers. Larger structures than dogbones were then successfully printed.

### Example 11

The following materials were weighed; Urethane diemthacrylate: 155g, Triethylene glycol dimethacrylate 3g, Kollisolv PEG E300 10g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium 2g, P122SB 311g, P122B 156g and Disperbik110 (dispersant) 2ml. The viscosity of the binder was 1100 mPa.s (1100 cPs). A 500ml metal tin was loaded with UDMA, TEGMA and Kollisolv PEG E300. The alumina particles were added portion wise at the high shear mixer (1000-4500 rpm) while adding Disperbik110 via syringe. P122B was added first, followed by the addition of P122SB. The Bis eta 5-2,4-cyclopentadien-1-yl) Bis [2,6-difluoro-3-(1H-pyrorol-1-yl) was added to the warm reaction mixture, which was kept in the oven at 50 degrees until all the Bis eta 5-2,4-cyclopentadien-1-yl) Bis [2,6-difluoro-3-(1H-pyrorol-1-yl) dissolved (24 hours). The printing of high resolution parts was completed successfully. The resin was, however, very viscous. Dogbones were printed on the Liquid Crystal HR printer at 70 seconds for 100 µm (100 micron) layers. Larger structures than dogbones were then successfully printed

### Example 12

The following materials were weighed; Urethane dimethacrylate 86, Triethylene glycol dimethacrylate 21g, Pentaerythritoltetra(3-mercaptopropionate) 3.2g, bis(η⁵-2,4-cyclopentadien-1-yl)-bis(2,6-difluoro-3-(1H-pyrrol-1-yl)-phenyl) titanium 2.1g and ZrO₂ from Saint Gobain CY3Z-MA (200nm) 250g. The viscosity of the photopolymer binder was 1100 mPa.s (1100 cPs). A 500ml metal tin was loaded with UDMA, TEGMA and Pentaerythritoltetra(3-mercaptopropionate). The zirconia particles (200nm) were added portion wise at the high shear mixer (1000-4500 rpm) while adding Disperbik110 via syringe. P122B was added first, followed by the addition of P122SB. The Bis eta 5-2,4-cyclopentadien-1-yl) Bis [2,6-difluoro-3-(1H-pyrorol-1-yl) was added to the warm reaction mixture, which was kept in the oven at 50 degrees until all the Bis eta 5-2,4-cyclopentadien-1-yl) Bis [2,6-difluoro-3-(1H-pyrorol-1-yl) dissolved (24 hours). The printing of high resolution parts was completed successfully. The resin was however, very viscous. Dogbones were printed on the Liquid Crystal HR printer at 60 seconds for 100 µm (100 micron) layers. Larger structures than dogbones were then successfully printed.

In examples 13 to 25 the Liquid Crystal Precision Printer from Photocentric of Peterborough was used.

### Example 13

The following materials were weighed; Urethane dimethacrylate 155g, Triethylene glycol dimethacrylate 35g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium 2g, P122SB 311g, P122B 156g, Disperbik110 (dispersant) 3ml and Edaplan 930 0.3ml. The photopolymer binder viscosity was 1100 mPa.s (1100 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik110 via syringe. P122B was added first, followed by the addition of P122SB and Edaplan 930. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 14

The following materials were weighed; Urethane dimethacrylate 155g, Triethylene glycol dimethacrylate 35g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium 2g, P122SB 467g, Disperbik110 (dispersant) 3ml and Edaplan 930 0.3ml. The photopolymer binder viscosity was 1100 mPa.s (1100 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik110 and Edaplan 930 via syringe. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours).

The printing of high resolution parts was completed successfully. 3D objects were printed on the Liquid Crystal Precision printer at 20 seconds for 50 µm (50 micron) layers.

### Example 15

The following materials were weighed; Urethane dimethacrylate 155g, Triethylene glycol dimethacrylate 35g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium 2g, 26N-0811UPA 467g, Disperbik110 (dispersant) 4ml and Edaplan 930 0.3ml. The photopolymer binder viscosity was 1100 mPa.s (1100 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik110 and Edaplan 930 via syringe. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). An agglomeration of the alumina particles was observed after 12 hours in the oven, which can be mainly attributed the particle size. The printing of high resolution parts was completed successfully. 3D objects were printed on the Liquid Crystal Precision printer at 20 seconds for 50 µm (50 micron) layers. Due to the agglomeration of the particles, the particle distribution in the 3D printed object is not homogenous, leading to uneven samples.

### Example 16

The following materials were weighed; Urethane dimethacrylate 155g, Triethylene glycol dimethacrylate 35g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium 2g, Polyethylene glycol 300 10g, P122SB 311g, P122B 156g, Disperbik110 (dispersant) 3ml and Edaplan 930 0.3ml. The photopolymer binder viscosity was 1100 mPa.s (1100 cPs). A 500ml metal tin was loaded with UDMA, TEGMA, polyethylene glycol 300, and Pentaerythritoltetra(3-mercaptopropionate). The alumina particles were added portion wise at the high shear mixer (1000-4500 rpm) while adding Disperbik110 via syringe. P122B was added first, followed by the addition of P122SB and Edaplan 930. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 17

The following materials were weighed; Urethane dimethacrylate 155g, Triethylene glycol dimethacrylate 35g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium: 2g, AA-03 467g, Disperbik110 (dispersant) 3ml and Edaplan 930 0.3ml. The photopolymer binder viscosity was 1100 mPa.s (1100 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik110 and Edaplan 930 via syringe. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 18

The following materials were weighed; Urethane dimethacrylate 155g, Triethylene glycol dimethacrylate 35g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium 2g, AES-11 467g, Disperbik110 (dispersant) 3ml and Edaplan 930 0.3ml. The photopolymer binder viscosity was 1100 mPa.s (1100 cPs). A 500ml metal tin was loaded with UDMA, TEGMA and Pentaerythritoltetra(3-mercaptopropionate). The alumina particles were added portion wise at the high shear mixer (1000-4500 rpm) while adding Disperbik110 and Edaplan 930 via syringe. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). An agglomeration of the alumina particles was observed after 12 hours in the oven, which can be mainly attributed the nearly spherical particle shape. The printing of high resolution parts was completed successfully. 3D objects were printed on the Liquid Crystal Precision printer at 20 seconds for 50 µm (50 micron) layers.

### Example 19

The following materials were weighed; Urethane dimethacrylate 155g, Triethylene glycol dimethacrylate 35g, Pentaerythritoltetra(3-mercaptopropionate) 3g, Polyetehylene glycol 300 10g, bis(η⁵-2,4-cyclopentadien-1-yl)-bis(2,6-difluoro-3-(1H-pyrrol-1-yl)-phenyl) titanium 2g, P122SB 467g, Disperbik110 (dispersant) 3ml and Edaplan 930 0.3ml. The photopolymer binder viscosity was 1100 mPa.s (1100 cPs). A 500ml metal tin was loaded with UDMA, TEGMA, polyethylene glycol 300, and Pentaerythritoltetra(3-mercaptopropionate). The alumina particles were added portion wise at the high shear mixer (1000-4500 rpm) while adding Disperbik110 and Edaplan via syringe. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 20

The following materials were weighed; Urethane dimethacrylate 155g, Triethylene glycol dimethacrylate 35g, Pentaerythritoltetra(3-mercaptopropionate) 3g, Polyetehylene glycol 300 10g, bis(η⁵-2,4-cyclopentadien-1-yl)-bis(2,6-difluoro-3-(1H-pyrrol-1-yl)-phenyl) titanium 2g, P662SB-03 467g, Disperbik110 (dispersant) 3ml and Edaplan 930 0.3ml. The photopolymer binder viscosity was 1100 mPa.s (1100 cPs). A 500ml metal tin was loaded with UDMA, TEGMA, polyethylene glycol 300, and Pentaerythritoltetra(3-mercaptopropionate). The alumina particles were added portion wise at the high shear mixer (1000-4500 rpm) while adding Disperbik110 via syringe. P122B was added first, followed by the addition of P122SB and Edaplan 930. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 21

The following materials were weighed; Urethane dimethacrylate 155g, Triethylene glycol dimethacrylate 35g, Pentaerythritoltetra(3-mercaptopropionate) 3g, Polyetehylene glycol 300 10g, bis(η⁵-2,4-cyclopentadien-1-yl)-bis(2,6-difluoro-3-(1H-pyrrol-1-yl)-phenyl) titanium 2g, DAM 07 50g, DAM 03 150g, DAM 01 267g, Disperbik110 (dispersant) 3ml and Edaplan 930 0.3ml. The photopolymer binder viscosity was 1100 mPa.s (1100 cPs). A 500ml metal tin was loaded with UDMA, TEGMA, polyethylene glycol 300, and Pentaerythritoltetra(3-mercaptopropionate). The alumina particles were added portion wise at the high shear mixer (1000-4500 rpm) while adding Disperbik110 via syringe. DAM 07 was added first, followed by the addition of DAM 03, DAM 01 and Edaplan 930. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 22

The following materials were weighed; Urethane dimethacrylate 155g, Triethylene glycol dimethacrylate 35g, Pentaerythritoltetra(3-mercaptopropionate) 3g, Polyetehylene glycol 300 10g, bis(η⁵-2,4-cyclopentadien-1-yl)-bis(2,6-difluoro-3-(1H-pyrrol-1-yl)-phenyl) titanium 2g, P122SB 800g, Disperbik110 (dispersant) 3ml and Edaplan 930 0.3ml. The photopolymer binder viscosity was 1100 mPa.s (1100 cPs). A 500ml metal tin was loaded with UDMA, TEGMA, polyethylene glycol 300, and Pentaerythritoltetra(3-mercaptopropionate). The alumina particles were added portion wise at the high shear mixer (1000-4500 rpm) while adding Disperbik110 and Edaplan via syringe. The Bis (eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 23

The following materials were weighed; Urethane dimethacrylate 155g, Triethylene glycol dimethacrylate 35g, Pentaerythritoltetra(3-mercaptopropionate) 3g, Polyetehylene glycol 300 10g, bis(η⁵-2,4-cyclopentadien-1-yl)-bis(2,6-difluoro-3-(1H-pyrrol-1-yl)-phenyl) titanium 2g, P122SB 533g, P122B 267g, Disperbik110 (dispersant) 3ml and Edaplan 930 0.3ml. The photopolymer binder viscosity was 1100 mPa.s (1100 cPs). A 500ml metal tin was loaded with UDMA, TEGMA, polyethylene glycol 300, and Pentaerythritoltetra(3-mercaptopropionate). The alumina particles were added portion wise at the high shear mixer (1000-4500 rpm) while adding Disperbik110 via syringe. P122B was added first, followed by the addition of P122SB and Edaplan 930. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 24

The following materials were weighed; Urethane dimethacrylate 86g, Triethylene glycol dimethacrylate 21g, Pentaerythritoltetra(3-mercaptopropionate) 1.7g, bis(η⁵-2,4-cyclopentadien-1-yl)-bis(2,6-difluoro-3-(1H-pyrrol-1-yl)-phenyl) titanium 1.1g, CY3Z-MA 250g and Disperbik110 (dispersant) 2ml. The photopolymer binder viscosity was 1100 mPa.s (1100 cPs). A 500ml metal tin was loaded with UDMA, TEGMA, and Pentaerythritoltetra(3-mercaptopropionate). The zirconia particles were added portion wise at the high shear mixer (1000-4500 rpm) while adding Disperbik110 via syringe. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 50 µm (50 micron) layers.

### Example 25

The following materials were weighed; Urethane dimethacrylate 200g, Pentaerythritoltetra(3-mercaptopropionate) 3g, bis(η⁵-2,4-cyclopentadien-1-yl)-bis(2,6-difluoro-3-(1H-pyrrol-1-yl)-phenyl) titanium 2g, Ni-718 100g and Disperbik110 (dispersant) 4ml. The photopolymer binder viscosity was 10000 mPa.s (10000 cPs). A 500ml metal tin was loaded with UDMA and Pentaerythritoltetra(3-mercaptopropionate). The metal particles were added portion wise at the high shear mixer (1000-4500 rpm) while adding Disperbik110 via syringe. The Bis eta 5-2,4-cyclopentadien-1-yl) Bis [2,6-difluoro-3-(1H-pyrorol-1-yl) was added to the warm reaction mixture, which was kept in the oven at 50 degrees until all photoinitiator dissolved (12 hours). The printing of high resolution parts was completed successfully. 3D objects were printed on the Liquid Crystal Precision printer at 20 seconds for 100 µm (100 micron) layers.

### Sintering cycles

Various combinations of de-binding and sintering combinations were tried. It was found that that the use of a very slow heating ramp during the de-binding process is beneficial when obtaining dense ceramic parts, the density being determined by SEM. In order to determine the de-binding conditions TG-DSC measurements can also be carried out. The following is an optimized sintering cycle for alumina resins in comparative example 7 and examples 8-11 and 12-23:
a) 0°C to 350°C: heating rate: 10°C/hr; hold at 350°C for 120 min
b) 350°C to 600°C: heating rate: 20°C/hr; hold at 600°C for 120 min
c) 600°C to 1630°C: heating rate: 30°C/hr; hold at 1630°C for 300 min

This is shown in Fig. 9. This cycle was designed using the results obtained from the TG-DSC analysis, which shows that a slower heating rate during the de-binding cycle can lead to better sintering results. This cycle showed no cracks and almost no formation of bubbles blisters during the de-binding/sintering cycle.

## Claims

1. A particulate mixture for forming 3-dimensional objects when exposed to visible light, the mixture comprising:
a liquid photopolymer formulation; and
a plurality of particles; wherein the particles are selected from: sand; a mixture
of sand and glass; metal; ceramic; or a mixture of metal and ceramic;
wherein the photopolymer formulation comprises:
at least one monomeric or oligomeric chemical species each comprising at least one carbon-carbon double bond which is polymerisable by free radical polymerisation present in a total amount of from 40 to 98% by weight;
at least one organometallic or metallocene photoinitiator present in a total amount of from 0.1 to 10% by weight;
at least one coinitiator present in a total amount of from 0.5 to 20% by weight; and
wherein the components of the photopolymer formulation are selected such that the viscosity of the photopolymer formulation is greater than 800 mPa.s (800 cPs).

2. A particulate mixture of claim 1, wherein the total amount of photoinitiator present in the photopolymer formulation is from 0.5 to 2.5% by weight.

3. A particulate mixture of claim 1 or 2, wherein the photoinitiator is a titanocene; optionally wherein the photoinitiator is bis(η⁵-2,4-cyclopentadien-1-yl)-bis(2,6-difluoro-3-(1H-pyrrol-1-yl)-phenyl) titanium.

4. A particulate mixture of any one of claims 1 to 3, wherein the total amount of coinitiator present in the photopolymer formulation is from 1 to 10% by weight.

5. A particulate mixture of any one of claims 1 to 4, wherein the coinitiator is a thiol coinitiator.

6. A particulate mixture of any one of claims 1 to 5, wherein the at least one monomeric or oligomeric chemical species each comprising at least one carbon-carbon double bond which is polymerisable by free radical polymerisation comprises Bisphenol A-glycidyl methacrylate (BisGMA) or Urethane dimethacrylate (UDMA); optionally
wherein the at least one monomeric or oligomeric chemical species each comprising at least one carbon-carbon double bond which is polymerisable by free radical polymerisation comprises UDMA in combination with Triethylene glycol dimethacrylate (TEGMA).

7. A particulate mixture of any one of claims 1 to 6, wherein the particles are sand or a mixture of sand and glass.

8. A particulate mixture of any one of claims 1 to 7 wherein the particles are metal, ceramic or a mixture thereof.

9. A particulate mixture of any one of claims 1 to 8 wherein the amount of particles in the particulate mixture is from 40 to 90% by weight.

10. A liquid photopolymer formulation for mixing with a plurality of particles to form a particulate mixture of any one of claims 1 to 9, the photopolymer formulation being as described in any one of claims 1 to 6.

11. A method for creating a 3-dimensional object, the method comprising:
a) forming a layer of a particulate mixture of any one of claims 1 to 9;
b) exposing the layer of the particulate mixture to visible light to form a cured layer; and
c) sequentially repeating steps a) and b), with each layer of particulate mixture being laid on top of each previously cured layer, to form a 3D object formed of particles bound together by cured photopolymer.

12. A method of claim 11, wherein the particulate mixture that is formed into a layer is pre-mixed.

13. A method of anyone of claim 11 or claim 12, wherein the visible light is from a visual display screen and is in the form of an image, said image being a cross-section of the desired 3D object; optionally wherein the visual display screen is a liquid crystal display screen (LCD).

14. A method of any one of claims 11 to 13, wherein the method further comprises washing the 3D object comprising the particles bound by the cured photopolymer to remove excess particles and/or excess photopolymer

15. A method of any one of claims 11 to 14, wherein the particles are metal or ceramic and wherein the method further comprises heating the 3D object formed of particles bound together by cured photopolymer to form a metal or ceramic 3D object; optionally wherein the step of heating the object comprises:
heating the 3D object formed of particles bound together by cured photopolymer to a first temperature to remove the cured photopolymer;
heating the resultant 3D object to a second temperature, higher than the first temperature, to sinter the particles to form the metal or ceramic 3D object.

## Patentansprüche

1. Partikelgemisch zum Bilden 3-dimensionaler Objekte, wenn an sichtbares Licht ausgesetzt, wobei das Gemisch umfasst:
eine flüssige Photopolymerformulierung; und
eine Vielzahl von Partikeln; wobei die Partikel ausgewählt sind aus: Sand; einem Gemisch aus Sand und Glas; Metall; Keramik; oder einem Gemisch aus Metall und Keramik;
wobei die Photopolymerformulierung umfasst:
wenigstens eine monomere oder oligomere chemische Spezies, die jeweils wenigstens eine Kohlenstoff-Kohlenstoff-Doppelbindung umfasst, die durch freie radikale Polymerisation polymerisierbar ist, die in einer Gesamtmenge von 40 bis 98 Gew.-% vorhanden ist;
wenigstens einen organometallischen oder metallocenen Photoinitiator, der in einer Gesamtmenge von 0,1 bis 10 Gew.-% vorhanden ist;
wenigstens einen Coinitiator, der in einer Gesamtmenge von 0,5 bis 20 Gew.-% vorhanden ist;
und
wobei die Komponenten der Photopolymerformulierung so ausgewählt sind, dass die Viskosität der Photopolymerformulierung größer als 800 mPa.s (800 cPs) ist.

2. Partikelgemisch nach Anspruch 1, wobei die Gesamtmenge an Photoinitiator, die in der Photopolymerformulierung vorhanden ist, von 0,5 bis 2,5 Gew.-% beträgt.

3. Partikelgemisch nach Anspruch 1 oder 2, wobei der Photoinitiator ein Titanocen ist; optional, wobei der Photoinitiator Bis(η⁵-2,4-cyclopentadien-1-yl)-bis(2,6-difluor-3-(1H-pyrrol-1-y1)-phenyl)titan ist.

4. Partikelgemisch nach einem der Ansprüche 1 bis 3, wobei die Gesamtmenge an Coinitiator, die in der Photopolymerformulierung vorhanden ist, von 1 bis 10 Gew.-% beträgt.

5. Partikelgemisch nach einem der Ansprüche 1 bis 4, wobei der Coinitiator ein Thiol-Coinitiator ist.

6. Partikelgemisch nach einem der Ansprüche 1 bis 5, wobei die mindestens eine monomere oder oligomere chemische Spezies, die jeweils mindestens eine Kohlenstoff-Kohlenstoff-Doppelbindung umfasst, die durch freie radikale Polymerisation polymerisierbar ist, Bisphenol A-Glycidylmethacrylat (BisGMA) oder Urethan-Dimethacrylat (UDMA) umfasst; optional,
wobei die mindestens eine monomere oder oligomere chemische Spezies, die jeweils mindestens eine Kohlenstoff-Kohlenstoff-Doppelbindung umfasst, die durch freie radikale Polymerisation polymerisierbar ist, UDMA in Kombination mit Triethylenglykoldimethacrylat (TEGMA) umfasst.

7. Partikelgemisch nach einem der Ansprüche 1 bis 6, wobei die Partikel Sand oder ein Gemisch aus Sand und Glas sind.

8. Partikelgemisch nach einem der Ansprüche 1 bis 7, wobei die Partikel Metall, Keramik oder ein Gemisch davon sind.

9. Partikelgemisch nach einem der Ansprüche 1 bis 8, wobei die Menge an Partikeln in dem Partikelgemisch von 40 bis 90 Gew.-% beträgt.

10. Flüssige Photopolymerformulierung zum Mischen mit einer Vielzahl von Partikeln, um ein Partikelgemisch nach einem der Ansprüche 1 bis 9 zu bilden, wobei die Photopolymerformulierung wie in einem der Ansprüche 1 bis 6 beschrieben ist.

11. Verfahren zum Erstellen eines 3-dimensionalen Objekts, wobei das Verfahren umfasst:
a) Bilden einer Schicht aus einem Partikelgemisch nach einem der Ansprüche 1 bis 9;
b) Aussetzen der Schicht des Partikelgemischs an sichtbares Licht, um eine ausgehärtete Schicht zu bilden; und
c) sequenzielles Wiederholen von Schritten a) und b), wobei jede Schicht des Partikelgemischs oben auf jede zuvor ausgehärtete Schicht gelegt wird, um ein 3D-Objekt zu bilden, das aus Partikeln gebildet ist, die durch ausgehärtetes Photopolymer miteinander verbunden sind.

12. Verfahren nach Anspruch 11, wobei das Partikelgemisch, das zu einer Schicht gebildet wird, vorgemischt wird.

13. Verfahren nach einem der Ansprüche 11 oder Anspruch 12, wobei das sichtbare Licht von einem Sichtanzeigebildschirm stammt und in Form eines Bildes vorliegt, wobei das Bild ein Querschnitt des gewünschten 3D-Objekts ist; gegebenenfalls, wobei der Sichtanzeigebildschirm ein Flüssigkristallanzeigebildschirm (LCD) ist.

14. Verfahren nach einem der Ansprüche 11 bis 13, wobei das Verfahren ferner das Waschen des 3D-Objekts umfasst, das die Partikel umfasst, die durch das ausgehärtete Photopolymer gebunden sind, um überschüssige Partikel und/oder überschüssiges Photopolymer zu entfernen.

15. Verfahren nach einem der Ansprüche 11 bis 14, wobei die Partikel Metall oder Keramik sind und wobei das Verfahren ferner das Erhitzen des 3D-Objekts, das aus Partikeln gebildet ist, die durch ausgehärtetes Photopolymer miteinander verbunden sind, um ein Metall- oder Keramik-3D-Objekt zu bilden, umfasst; optional, wobei der Schritt des Erhitzens des Objekts umfasst:
Erhitzen des 3D-Objekts, das aus Partikeln gebildet ist, die durch ausgehärtetes Photopolymer miteinander verbunden sind, auf eine erste Temperatur, um das ausgehärtete Photopolymer zu entfernen;
Erhitzen des resultierenden 3D-Objekts auf eine zweite Temperatur, die höher als die erste Temperatur ist, um die Partikel zu sintern, um das Metall- oder Keramik-3D-Objekt zu bilden.

## Revendications

1. Mélange particulaire destiné à la formation d'objets à 3 dimensions lorsqu'ils sont exposés à la lumière visible, le mélange comprenant :
une formulation de photopolymère liquide ; et
une pluralité de particules ; lesdites particules étant choisies parmi : du sable ; un mélange de sable et de verre ; du métal ; de la céramique ; ou un mélange de métal et de céramique ;
ladite formulation de photopolymère comprenant :
au moins une espèce chimique monomère ou oligomère comprenant chacune au moins une double liaison carbone-carbone polymérisable par polymérisation radicalaire présente en une quantité totale de 40 à 98 % en poids ;
au moins un photoamorceur organométallique ou métallocène présent en une quantité totale de 0,1 à 10 % en poids ;
au moins un co-amorceur présent en une quantité totale de 0,5 à 20 % en poids ;
et
lesdits composants de la formulation photopolymère étant choisis de sorte que la viscosité de la formulation photopolymère soit supérieure à 800 mPa.s (800 cPs).

2. Mélange particulaire selon la revendication 1, ladite quantité totale de photoamorceur présent dans la formulation de photopolymère étant de 0,5 à 2,5 % en poids.

3. Mélange particulaire selon la revendication 1 ou 2, ledit photoamorceur étant un titanocène ; éventuellement, ledit photoamorceur étant le bis(η⁵-2,4-cyclopentadiène-l-yl)-bis(2,6-difluoro-3-(1H-pyrrol-1-yl)-phényl)titane.

4. Mélange particulaire selon l'une quelconque des revendications 1 à 3, ladite quantité totale de co-amorceur présent dans la formulation de photopolymère étant de 1 à 10 % en poids.

5. Mélange particulaire selon l'une quelconque des revendications 1 à 4, ledit co-amorceur étant un co-amorceur thiol.

6. Mélange particulaire selon l'une quelconque des revendications 1 à 5, ladite au moins une espèce chimique monomère ou oligomère comprenant chacune au moins une double liaison carbone-carbone qui est polymérisable par polymérisation radicalaire comprenant le méthacrylate de glycidyle et de bisphénol A (BisGMA) ou le diméthacrylate d'uréthane (UDMA) ; éventuellement
ladite au moins une espèce chimique monomère ou oligomère comprenant chacune au moins une double liaison carbone-carbone qui est polymérisable par polymérisation radicalaire comprenant de l'UDMA en combinaison avec du diméthacrylate de triéthylène glycol (TEGMA).

7. Mélange particulaire selon l'une quelconque des revendications 1 à 6, lesdites particules étant du sable ou un mélange de sable et de verre.

8. Mélange particulaire selon l'une quelconque des revendications 1 à 7, lesdites particules étant en métal, en céramique ou un mélange de ceux-ci.

9. Mélange particulaire selon l'une quelconque des revendications 1 à 8, ladite quantité de particules dans le mélange particulaire étant de 40 à 90 % en poids.

10. Formulation photopolymère liquide destinée à être mélangée avec une pluralité de particules pour former un mélange particulaire selon l'une quelconque des revendications 1 à 9, la formulation photopolymère étant telle que décrite dans l'une quelconque des revendications 1 à 6.

11. Procédé permettant la création d'un objet à 3 dimensions, le procédé comprenant :
a) la formation d'une couche d'un mélange particulaire selon l'une quelconque des revendications 1 à 9 ;
b) l'exposition de la couche du mélange particulaire à la lumière visible pour former une couche durcie ; et
c) la répétition séquentielle des étapes a) et b), chaque couche de mélange particulaire étant déposée sur le dessus de chaque couche préalablement durcie, pour former un objet 3D formé de particules liées ensemble par un photopolymère durci.

12. Procédé selon la revendication 11, ledit mélange particulaire qui est formé en une couche étant au préalable mélangé.

13. Procédé selon l'une quelconque des revendications 11 ou 12, ladite lumière visible provenant d'un écran d'affichage visuel et se présentant sous la forme d'une image, ladite image étant une coupe transversale de l'objet 3D souhaité ; éventuellement, ledit écran d'affichage visuel étant un écran d'affichage à cristaux liquides (LCD).

14. Procédé selon l'une quelconque des revendications 11 à 13, ledit procédé comprenant en outre le lavage de l'objet 3D comprenant les particules liées par le photopolymère durci pour éliminer les particules en excès et/ou le photopolymère en excès.

15. Procédé selon l'une quelconque des revendications 11 à 14, lesdites particules étant en métal ou en céramique et ledit procédé comprenant en outre le chauffage de l'objet 3D formé de particules liées ensemble par un photopolymère durci pour former un objet 3D en métal ou en céramique ; éventuellement ladite étape de chauffage de l'objet comprenant :
le chauffage de l'objet 3D formé de particules liées ensemble par un photopolymère durci jusqu'à une première température pour éliminer le photopolymère durci ;
le chauffage de l'objet 3D résultant jusqu'à une seconde température, supérieure à la première température, pour fritter les particules afin de former l'objet 3D en métal ou en céramique.
